# FASCICULE DE BREVET EUROPEEN

(11) **EP 2 908 096 B1**
(45) Date de publication et mention de la délivrance du brevet: **26.07.2017**
(21) Numéro de dépôt: 15153736.2
(22) Date de dépôt: 04.02.2015
(51) Int. Cl.: G01D 4/00, G01D 5/39, G06K 19/06

(54) **Dispositif électronique de mesure apte à afficher des données sous forme d'un code matriciel à deux dimensions, lecteur électronique, installation électronique et procédé de transmission associés**
Elektronische Messvorrichtung, die in der Lage ist, Daten in Form eines 2D-Matrixcodes anzuzeigen, entsprechendes elektronisches Lesegerät, entsprechende elektronische Anlage und entsprechendes Übertragungsverfahren
Electronic measurement device capable of displaying data in the form of a two-dimensional matrix code, associated electronic reader, electronic system and transmission method

(30) Priorité: 12.02.2014 FR 1451084
(43) Date de publication de la demande: 19.08.2015
(73) Titulaire: Schneider Electric Industries SAS, 92500 Rueil-Malmaison (FR)
(72) Inventeur: Miry, Jean-Marc, 38050 Grenoble Cedex 09 (FR)
(74) Mandataire: Lavoix

(56) Documents cités:
- EP-A2- 0 910 032
- EP-A2- 2 088 706
- WO-A1-2013/046231
- US-A1- 2011 303 754
- US-A1- 2013 345 623
- "Copyright 2011 DENSO ADC", , 31 mars 2011 (2011-03-31), XP055104966, Extrait de l'Internet: URL:http://www.nacs.org/LinkClick.aspx?fil eticket=D1FpVAvvJuo=&tabid=1426&mid=4802 [extrait le 2014-02-28]

## Description

La présente invention concerne un dispositif électronique de mesure d'une grandeur, telle qu'une grandeur électrique ou une grandeur thermodynamique. Le dispositif de mesure comprend un organe de mesure de la grandeur, apte à délivrer des données de mesure, et un organe de codage apte à convertir des données de mesure en données structurées selon un format de structuration, les données structurées selon le format de structuration comportant au moins une partie des données de mesure. Le dispositif de mesure comprend un organe de génération d'au moins un code matriciel à deux dimensions à partir des données structurées, et un organe d'affichage apte à afficher chaque code matriciel généré.

L'invention concerne également un lecteur électronique apte à lire un code matriciel à deux dimensions affiché par un tel dispositif électronique.

L'invention concerne également une installation électronique de mesure de ladite grandeur, comprenant un tel dispositif électronique et un tel lecteur électronique.

L'invention concerne également un procédé de transmission de données de mesure de ladite grandeur entre un tel dispositif électronique et un tel lecteur électronique.

On connait du document WO 2013/046231 A1 un capteur de mesure apte à afficher des données mesurées, de façon dynamique et sous la forme de codes matriciels à deux dimensions, tels que des codes QR (de l'anglais *Quick Response*). Les codes matriciels sont affichés successivement dans le temps. Chaque code matriciel représente une trame de données mesurées selon un format de structuration prédéterminé. Les codes matriciels de type QR sont en particulier connus d'une brochure de la société DENSO ADC, datée de 2011 et nommée « QR Code Essentials ». On connaît également du document EP 2 088 706 A2 décrit un compteur électrique configuré pour transmettre des messages par communication radiofréquence.

Le document WO 2013/046231 A1 décrit également un lecteur de codes matriciels QR, apte à lire les codes matriciels affichés par le capteur et apte à extraire desdits codes QR lus les données mesurées représentées selon le format de structuration. Le format prédéterminé de structuration des données, représentées par les codes matriciels, est également connu du lecteur. Il est alors apte à extraire les trames de données mesurées, à partir des codes matriciels lus et en fonction de ce format.

Toutefois, il existe un grand nombre de formats de structuration de données, ces formats dépendant par exemple du type de capteur, de la grandeur mesurée et/ou des normes de mesure utilisées. L'utilisation d'un tel capteur de mesure est donc relativement complexe, et nécessite un lecteur spécifique.

Le but de l'invention est de proposer un dispositif de mesure, apte à afficher des données de mesure sous forme d'un code matriciel à deux dimensions, qui soit plus facile à utiliser et avec un plus grand nombre de lecteurs de code matriciel compatibles.

A cet effet, l'invention a pour un objet un dispositif de mesure du type précité, dans lequel le dispositif de mesure est selon la revendication 1.

Suivant d'autres aspects avantageux de l'invention, le dispositif de mesure est selon l'une des revendications 2 et 3.

L'invention a également pour objet un lecteur électronique, selon la revendication 4.

Suivant d'autres aspects avantageux de l'invention, le lecteur électronique est selon l'une des revendications 5 à 7.

L'invention a également pour objet une installation électronique de mesure d'une grandeur, telle qu'une grandeur électrique ou une grandeur thermodynamique, selon la revendication 8.

L'invention a également pour objet un procédé de transmission de données de mesure d'une grandeur, telle qu'une grandeur électrique ou une grandeur thermodynamique, selon la revendication 9.

Suivant un autre aspect avantageux de l'invention, le procédé de transmission de données est selon la revendication 10.

Ces caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'une installation électronique selon l'invention, l'installation comprenant un dispositif électronique de mesure, apte à afficher des données de mesure sous forme d'un code matriciel à deux dimensions et un lecteur électronique du ou des codes matriciels affichés par le dispositif de mesure,
- la figure 2 est une représentation schématique du dispositif de mesure de la figure 1,
- la figure 3 est une représentation schématique du lecteur électronique de la figure 1,
- la figure 4 est une représentation schématique d'une trame de données structurées,
- la figure 5 est une vue d'un code matriciel affiché par un organe d'affichage du dispositif de mesure de la figure 1, et
- la figure 6 est un organigramme d'un procédé de transmission de données de mesure selon l'invention.

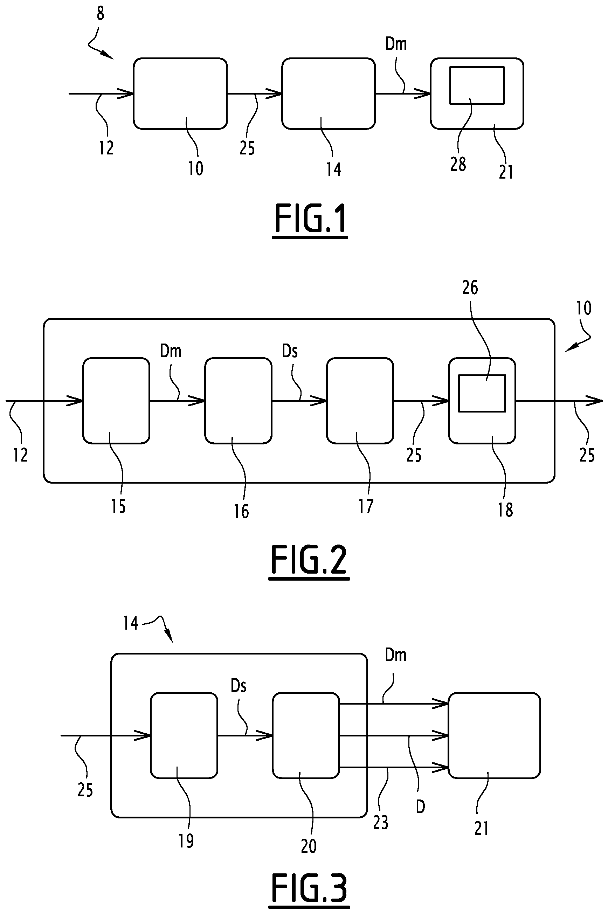

Sur la figure 1, une installation électronique 8 comprend un dispositif 10 de mesure d'une grandeur 12, telle qu'une grandeur électrique ou une grandeur thermodynamique, et un lecteur électronique 14 couplé au dispositif de mesure 10 pour lire des données relatives à la grandeur mesurée 12.

Le dispositif de mesure 10 comprend un organe 15 de mesure de la grandeur 12, un organe de codage 16, un organe 17 de génération d'une image correspondant à la grandeur mesurée, et un organe 18 d'affichage de ladite image, comme représenté sur la figure 2.

Le lecteur électronique 14 comprend un organe 19 de lecture de la ou chaque image affichée par le dispositif de mesure et un organe de décodage 20, comme représenté sur la figure 3.

En complément, le lecteur électronique 14 est relié à un appareil électronique 21 distant, et est apte à transmettre des informations issues de l'organe de décodage 20 à cet appareil électronique 21.

L'organe de mesure 15, visible sur la figure 2, est par exemple un ampèremètre mesurant un courant circulant dans une ligne électrique, un voltmètre mesurant la tension d'un conducteur électrique, ou encore un thermomètre mesurant une température dans une pièce. L'organe 15 est apte à mesurer la grandeur 12 à des instants de mesure Tm successifs, de préférence avec une périodicité prédéterminée.

L'organe de mesure 15 est apte à délivrer des données de mesure Dm correspondant aux valeurs prises successivement par la grandeur 12. L'organe de mesure 15 est, par exemple, apte à délivrer à chaque instant de mesure Tm une première trame de données représentative de la valeur de la grandeur 12 pour cet instant de mesure Tm. Les données de mesure Dm comportent alors une succession de premières trames de données, c'est-à-dire une séquence de premières trames de données.

L'organe de mesure 15 est apte à transmettre les données de mesure Dm à l'organe de codage 16 en vue de leur conversion en données structurées Ds, les premières trames de données étant par exemple transmises successivement à l'organe de codage 16, ou bien séquence par séquence.

L'organe de codage 16 est apte à convertir les données de mesure Dm en les données structurées Ds selon un format de structuration F. Cette conversion est par exemple effectuée trame par trame, ou bien séquence par séquence, et les premières trames de données sont alors converties en deuxièmes trames de données structurées correspondantes.

Chaque première trame de données et chaque deuxième trame de données sont, par exemple, de longueur prédéterminée. Autrement dit, chaque première trame de données et chaque deuxième trame de données sont composées d'un nombre prédéterminé d'octets.

En variante, chaque première trame de données et chaque deuxième trame de données sont de longueur variable. Autrement dit, chaque première trame de données et chaque deuxième trame de données comportent un nombre variable d'octets.

Les données de mesure Dm sont par exemple, exprimées sous forme d'une chaîne de caractères alphanumériques, de préférence sous forme de nombres décimaux. Les données structurées Ds sont, par exemple, exprimées sous forme d'une chaîne de caractères alphanumériques, par exemple sous forme de nombres décimaux ou hexadécimaux. Les données structurées Ds sont de préférence constituées de caractères alphanumériques.

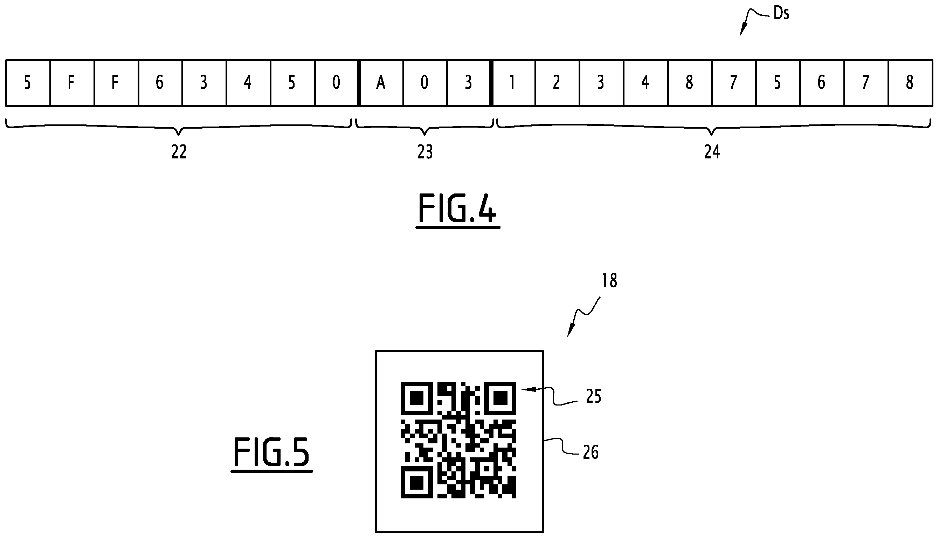

Chacune des deuxièmes trames de données structurées Ds comprend un premier identifiant 22 du format de structuration F, un deuxième identifiant 23 de la deuxième trame correspondante parmi la pluralité de deuxièmes trames de données structurées Ds et un champ de données formatées 24, comme représenté sur la figure 4.

Chaque deuxième trame de données structurées Ds est de préférence constituée du premier identifiant 22, du deuxième identifiant 23 et du champ de données formatées 24.

L'organe de codage 16, visible sur la figure 2, est apte à transmettre l'une après l'autre les deuxièmes trames de données structurées Ds à l'organe de génération 17. L'organe de génération 17 est apte à générer au moins un code matriciel à deux dimensions 25 à partir des données structurées Ds. L'organe de génération 17 est, par exemple, apte à générer un code matriciel à deux dimensions 25 pour chaque deuxième trame de données structurées.

Dans l'exemple de réalisation décrit, l'organe de codage 16 et l'organe de génération 17 sont réalisés sous forme de logiciels aptes à être stockés dans une mémoire, non représentée, et à être exécutés par un processeur, non représenté, associé à la mémoire, le processeur et la mémoire formant une unité de traitement d'informations incluse dans le dispositif de mesure 10.

En variante, l'organe de codage 16 et l'organe de génération 17 sont réalisés sous forme de composants logiques programmables, ou encore sous forme de circuits intégrés dédiés, inclus dans le dispositif de mesure 10.

L'organe d'affichage 18 est apte à afficher chaque code matriciel 25 généré. L'organe d'affichage 18 comporte par exemple un écran 26, visible sur la figure 5, apte à afficher le code matriciel 25 de taille prédéfinie.

L'organe de lecture 19, visible sur la figure 3, est apte à lire chaque code matriciel 25 affiché et à déterminer les données structurées Ds correspondant au code matriciel 25 lu. L'organe de lecture 19 est alors apte à transmettre ladite trame de données structurées Ds à l'organe de décodage 20.

L'organe de décodage 20 est apte à recevoir la trame de données structurées Ds transmise par l'organe de lecture 19. L'organe de décodage 20 est apte à récupérer un descriptif D du format de structuration F correspondant au premier identifiant 22.

L'organe de décodage 20 est par exemple connecté à un réseau informatique, tel que le réseau Internet, lui permettant de communiquer avec un serveur informatique, tel qu'un serveur Web, contenant le descriptif D du format de structuration F correspondant au premier identifiant 22. Le premier identifiant 22 est par exemple un lien internet vers un fichier contenu dans le serveur, ou est une partie d'un tel lien.

En variante, l'organe de décodage 20 comporte une mémoire, non représentée, dans laquelle est contenu le descriptif D du format de structuration F correspondant au premier identifiant 22.

L'organe de décodage 20 est apte à utiliser le descriptif D pour déterminer la trame de données de mesure Dm contenue dans chaque trame de données structurées Ds.

En complément, l'organe de décodage 20 est apte à transmettre la trame des données de mesure Dm, décodées à partir des données lues par l'organe de lecture 19, à l'appareil électronique distant 21.

Dans l'exemple de réalisation décrit, l'organe de lecture 19 et l'organe de décodage 20 sont réalisés au moins partiellement sous forme de logiciels aptes à être stockés dans une mémoire, non représentée, et à être exécutés par un processeur, non représenté, associé à la mémoire, le processeur et la mémoire formant une unité de traitement d'informations incluse dans le lecteur électronique 14.

En variante, l'organe de lecture 19 et l'organe de décodage 20 sont réalisés au moins partiellement sous forme de composants logiques programmables, ou encore sous forme de circuits intégrés dédiés, inclus dans le lecteur électronique 14.

Le dispositif de mesure 10 est alors de préférence apte à transmettre chacune des deuxièmes trames de données structurées Ds sous forme de codes matriciels 25 au lecteur électronique 14. Le lecteur électronique 14 est alors apte à transmettre, à l'appareil électronique distant 21, chacune des trames de données de mesure Dm, à partir des deuxièmes trames de données structurées Ds décodées par l'organe de décodage 20 en fonction du premier identifiant 22 contenu dans les données structurées Ds, les deuxièmes trames de données structurées Ds étant elles-mêmes obtenues par l'organe de lecture 19 à partir des codes matriciels 25 lus, ces derniers étant affichés à l'écran 26 du dispositif de mesure.

L'appareil électronique 21 comprend par exemple un deuxième écran 28 et est apte à recevoir les informations issues du lecteur 14, en particulier de l'organe de décodage 20. L'appareil électronique 21 est apte à afficher au moins en partie des informations issues du lecteur 14, et sous une forme compréhensible par un opérateur.

Le premier identifiant 22, visible sur la figure 4, est un nombre unique pour chaque format de structuration F, et permettant d'identifier de manière unique le format de structuration F associé. Il s'agit, par exemple, d'une clé indiquant quel est le format utilisé par le dispositif de mesure 10 émettant la trame de données structurées Ds sous forme du code matriciel 25. Le premier identifiant 22 est exprimé de préférence sous la forme d'un nombre hexadécimal ou décimal.

Le deuxième identifiant 23 est un nombre unique pour chaque deuxième trame de données structurées Ds. Le deuxième identifiant 23 est apte à identifier la deuxième trame qui lui est associée parmi la séquence de deuxièmes trames de données structurées Ds. Le deuxième identifiant 23 est également appelé numéro de séquence.

Le deuxième identifiant 23 est de préférence un nombre décimal, et de préférence inclus dans l'en-tête de chaque deuxième trame de données structurées Ds.

A titre d'exemple, le deuxième identifiant 23 est un compteur qui est incrémenté par l'organe de codage 16 à chaque nouvelle première trame de données de mesure Dm reçue. Dans ce cas, le deuxième identifiant 23 de la deuxième trame initiale de données structurées Ds, c'est-à-dire de la deuxième trame placée en première position dans la séquence de deuxièmes trames, aura la valeur 1. Le deuxième identifiant 22 de la deuxième trame suivante de données structurées Ds, c'est-à-dire de la deuxième trame placée en deuxième position dans la séquence de deuxièmes trames, aura la valeur 2 et ainsi de suite. Le deuxième identifiant 23 est alors unique pour chaque deuxième trame de données structurées Ds parmi la pluralité de deuxièmes trames.

Le champ de données formatées 24 est déterminé par l'organe de codage 16, à partir d'une trame de données de mesure Dm et du format de structuration F.

Chaque code matriciel à deux dimensions 25, visible sur la figure 5, qui est affiché par l'écran 26 de l'organe d'affichage 18 correspond à une seule deuxième trame de données structurées Ds.

Chaque code matriciel à deux dimensions 25 est par exemple un code QR (de l'anglais *Quick Response code* ou *QR code*). Le code de type QR présente l'avantage de contenir plus d'informations qu'un code-barres classique.

Le code matriciel à deux dimensions 25 est, par exemple, composé de carrés noirs et blancs, qui correspondent respectivement aux chiffres 0 et 1. Chaque carré contient dans ce cas un bit d'information.

Le format de structuration F détermine la troncature de la trame de données de mesure Dm, le nombre de chiffres avant et après la virgule si c'est un nombre décimal, ainsi qu'éventuellement un autre paramètre définissant le format du nombre associé, ces informations étant contenues dans un descriptif D.

Le descriptif D du format de structuration F est par exemple en forme d'un fichier au format XML (de l'anglais *Extensible Markup Language*) ou au format JSON (de l'anglais *JavaScript Object Notation*), ou encore tout autre langage descriptif.

Le descriptif D comprend des informations représentatives de la trame de données de mesure Dm. Le descriptif contient par exemple la longueur de la trame de données de mesure Dm, s'il y a une troncature, et d'autres informations propre à la trame de données de mesure Dm qui sont utiles à transmettre au lecteur.

En complément, le descriptif D du format de structuration F comprend des informations représentatives de la nature de la grandeur 12 mesurée par le dispositif 10, telles qu'un titre et une description de la grandeur mesurée, du constructeur du dispositif 10, de sa date de fabrication et d'autres informations propres au dispositif 10.

En complément encore, le descriptif D du format de structuration F comprend un paramètre indiquant la visibilité ou non de la trame correspondante. Ce paramètre permet alors de n'afficher que les informations relatives à certaines mesures effectuées parmi l'ensemble des mesures effectuées.

Par exemple, l'organe de mesure 15 du dispositif 10 est un ampèremètre qui mesure une valeur de 2,3456 ampères. L'organe de mesure 15 fournit une trame de données de mesure Dm contenant sous forme chiffrée 2,3456. Le champ de données formatées 24 est exprimé par exemple par le chiffre 23456. Dans ce cas, la valeur mesurée par le dispositif 10, est retrouvée en introduisant la virgule après le premier chiffre du nombre contenu dans la trame de données de mesure Dm.

Dans l'exemple précédent, le descriptif D contient l'information que le champ de données formatées 24 contient un nombre qui a un chiffre avant la virgule et quatre chiffres après la virgule, et qu'elle représente une intensité électrique. Dans ce cas, l'organe de décodage 20 est apte à retrouver que la valeur contenue dans la trame de données de mesure Dm est 2,3456, et apte à transmettre cette valeur à l'appareil électronique distant 21.

L'organe de décodage 20 est apte à transmettre, à l'appareil électronique distant 21, les données de mesure Dm, le descriptif D du format de structuration F correspondant au premier identifiant 22, et éventuellement le deuxième identifiant 23. L'appareil électronique 21 est alors apte à recevoir les données de mesure Dm, le descriptif D du format correspondant au premier identifiant 22, ainsi qu'éventuellement le deuxième identifiant 23 lorsque les données de mesure Dm reçues correspondent à une deuxième trame respective parmi une pluralité de deuxièmes trames.

En reprenant l'exemple précédent, le deuxième écran 28 affiche « Intensité mesurée = 2,34 ampères ». L'opérateur lisant les données sur le deuxième écran 28 est alors capable de connaître les trames de données de mesure Dm correspondant aux valeurs mesurées par le dispositif de mesure 10.

Le deuxième écran 28 est également apte à afficher le deuxième identifiant 23, par exemple sous la forme « Numéro de la trame de données = 40 », si c'est le deuxième identifiant 23 associé à la quarantième trame de données structurées Ds.

En complément, le deuxième écran 28 est apte à afficher des informations contenues dans le descriptif D.

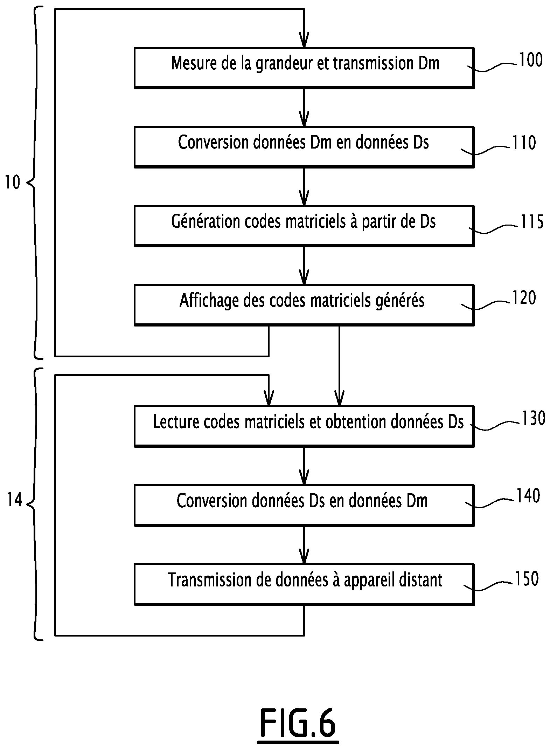

Le fonctionnement de l'installation électronique 8, du dispositif de mesure 10 et du lecteur électronique 14 va être décrit plus en détail à l'aide de la figure 6 représentant un organigramme du procédé de transmission selon l'invention.

Lors d'une étape initiale 100, l'organe de mesure 15 du dispositif 10 mesure la grandeur 12 et délivre périodiquement des premières trames de données de mesure Dm. Il transmet ensuite les trames de données de mesure Dm, l'une après l'autre, à l'organe de codage 16.

Lors d'une étape 110, l'organe de codage 16 convertit l'une après l'autre les premières trames de données de mesure Dm en deuxièmes trames de données structurées Ds, les données structurées Ds étant selon le format de structuration F. II transmet ensuite l'une après l'autre chacune des trames de données structurées Ds à l'organe de génération 17.

Selon l'invention, les données structurées Ds contiennent le premier identifiant 22 du format de structuration F, ledit premier identifiant 22 étant apte à identifier de manière unique le format de structuration.

Chaque deuxième trame de données structurées Ds contient de préférence le premier identifiant 22 caractéristique du format de structuration F, le deuxième identifiant 23 caractéristique de la deuxième trame correspondante, et le champ 24 de données formatées selon le format de structuration F.

L'organe de génération 17 génère alors, lors d'une étape suivante 115, un code matriciel à deux dimensions 25 pour chaque deuxième trame de données structurées Ds.

Lors d'une étape 120, l'organe d'affichage 18 affiche successivement, sur son écran 26, chacun des codes matriciels à deux dimensions 25 générés par l'organe de génération 17. L'écran 26 affiche une succession de codes matriciels à deux dimensions 25 correspondant à une succession de deuxièmes trames de données structurées Ds.

Lors d'une étape 130, l'organe de lecture 19 du lecteur électronique 14 lit chacun des codes matriciels à deux dimensions 25 affichés sur l'écran 26 de l'organe d'affichage du dispositif de mesure 10, et en déduit chacune des deuxièmes trames de données structurées Ds. L'organe de lecture 19 transmet ensuite ces trames de données structurées Ds, de préférence sous la forme de nombres, à l'organe de décodage 20.

Lors d'une étape 140, l'organe de décodage 20 reçoit la trame de données structurées Ds transmise par l'organe de lecture 19. L'organe de décodage 20 récupère le descriptif D correspondant au premier identifiant 22 du format de structuration F et utilise ce descriptif D pour déterminer la trame de données de mesure Dm contenue dans la trame de données structurées Ds.

L'organe de décodage 20 extrait alors chaque première trame de données de mesure Dm contenue dans les trames de données structurées Ds.

L'organe de décodage 20 transmet, lors d'une étape 150 et à l'appareil électronique distant 21, les données de mesure Dm, le deuxième identifiant 23 et le descriptif D correspondant au premier identifiant 22.

Le deuxième écran 28 de l'appareil électronique distant 21 reçoit ensuite les données de mesure Dm, le descriptif D du format correspondant au premier identifiant 22, ainsi qu'éventuellement le deuxième identifiant 23, et affiche les données selon une forme compréhensible pour un opérateur.

L'installation électronique 8 selon l'invention permet alors d'utiliser n'importe quel dispositif de mesure 10 conforme l'invention avec n'importe quel lecteur électronique 14 conforme à l'invention.

Le fait que le dispositif de mesure 10 transmette au lecteur 14 par l'intermédiaire du premier identifiant 22 un indicateur unique du format de structuration utilisé F permet au lecteur de mesure 14 de récupérer un descriptif D dudit format utilisé et de pouvoir alors lire les champs de données formatées 24. Autrement dit, le lecteur de mesure 14 et le dispositif de mesure 10 sont, selon l'invention, aptes à partager l'information mesurée à partir d'un identifiant, à savoir le premier identifiant 22 adapté pour identifier de manière unique le format de structuration F.

Le dispositif de mesure 10 est alors plus facile à utiliser et est utilisable avec un plus grand nombre de lecteurs de code matriciel 16 compatibles.

Le dispositif de mesure 10 et le lecteur de mesure 14 évoluant à des rythmes différents (par exemple au gré d'évolutions logicielles) un avantage supplémentaire de l'invention est de permettre une compatibilité de lecture / décodage qui soit pérenne dans le temps.

Selon une variante de réalisation, l'écran 26 de l'organe d'affichage 18 du dispositif 10 est apte à afficher simultanément un nombre N de codes matriciels à deux dimensions 25, N étant strictement supérieur à 1.

Le lecteur électronique 14 est également apte à lire simultanément le nombre N de codes matriciels à deux dimensions 25.

L'organe de génération 17 génère alors des codes matriciels 25 pour les trames de données structurées Ds issues les unes après les autres de l'organe de codage 16, et stocke les différents codes matriciels 25 générés.

Une fois que le nombre de codes matriciels 25 stockés dans l'organe de génération 17 est égal au nombre N, l'organe de génération 17 transfère les codes matriciels 25 générés à l'organe d'affichage 18 afin que les N codes matriciels 25 soient affichés simultanément sur l'écran 26.

Le lecteur électronique 14 lit les N codes matriciels 25, et l'organe de lecture 19 en déduit alors les trames de données structurées Ds associées et les transmet à l'organe de décodage 20 qui les stocke.

Chacune des trames de données structurées Ds stockées dans l'organe de décodage 20 est alors convertie en données de mesure par l'organe de décodage, de manière analogue à ce qui a été décrit précédemment.

Cette variante de réalisation permet alors d'augmenter le débit de la transmission d'informations entre le dispositif de mesure 10 et le lecteur électronique 14.

L'installation électronique 8 selon l'invention permet alors d'utiliser n'importe quel dispositif de mesure 10 conforme l'invention avec n'importe quel lecteur électronique 14 conforme à l'invention.

Le fait que le dispositif de mesure 10 transmette au lecteur 14 par l'intermédiaire du premier identifiant 22 un indicateur unique du format de structuration utilisé F permet au lecteur de mesure 14 de récupérer un descriptif D dudit format utilisé et de pouvoir alors lire les champs de données formatées 24. Autrement dit, le lecteur de mesure 14 et le dispositif de mesure 10 sont, selon l'invention, aptes à partager l'information mesurée à partir d'un identifiant, à savoir le premier identifiant 22 adapté pour identifier de manière unique le format de structuration F.

Le dispositif de mesure 10 est alors plus facile à utiliser et est utilisable avec un plus grand nombre de lecteurs de code matriciel 16 compatibles.

Le dispositif de mesure 10 et le lecteur de mesure 14 évoluant à des rythmes différents (par exemple au gré d'évolutions logicielles) un avantage supplémentaire de l'invention est de permettre une compatibilité de lecture / décodage qui soit pérenne dans le temps.

Selon une variante de réalisation, l'écran 26 de l'organe d'affichage 18 du dispositif 10 est apte à afficher simultanément un nombre N de codes matriciels à deux dimensions 25, N étant strictement supérieur à 1.

Le lecteur électronique 14 est également apte à lire simultanément le nombre N de codes matriciels à deux dimensions 25.

L'organe de génération 17 génère alors des codes matriciels 25 pour les trames de données structurées Ds issues les unes après les autres de l'organe de codage 16, et stocke les différents codes matriciels 25 générés.

Une fois que le nombre de codes matriciels 25 stockés dans l'organe de génération 17 est égal au nombre N, l'organe de génération 17 transfère les codes matriciels 25 générés à l'organe d'affichage 18 afin que les N codes matriciels 25 soient affichés simultanément sur l'écran 26.

Le lecteur électronique 14 lit les N codes matriciels 25, et l'organe de lecture 19 en déduit alors les trames de données structurées Ds associées et les transmet à l'organe de décodage 20 qui les stocke.

Chacune des trames de données structurées Ds stockées dans l'organe de décodage 20 est alors convertie en données de mesure par l'organe de décodage, de manière analogue à ce qui a été décrit précédemment.

Cette variante de réalisation permet alors d'augmenter le débit de la transmission d'informations entre le dispositif de mesure 10 et le lecteur électronique 14.

## Revendications

1. Dispositif électronique (10) de mesure d'une grandeur (12), telle qu'une grandeur électrique ou une grandeur thermodynamique, comprenant :
- un organe (15) de mesure de la grandeur (12), apte à délivrer des données de mesure (Dm),
- un organe de codage (16), apte à convertir des données de mesure (Dm) en données structurées (Ds) selon un format de structuration (F), les données structurées (Ds) selon le format de structuration (F) comportant au moins une partie des données de mesure (Dm),
- un organe (17) de génération d'au moins un code matriciel à deux dimensions (25) à partir des données structurées (Ds), et
- un organe d'affichage (18), apte à afficher chaque code matriciel généré (25),
**caractérisé en ce que** les données structurées (Ds) comprennent en outre un premier identifiant (22) du format de structuration (F), ledit premier identifiant (22) étant apte à identifier de manière unique le format de structuration (F),
les données de mesure (Dm) comportant des premières trames successives de données, et l'organe de codage (16) étant apte à convertir chaque première trame de données de mesure (Dm) en une deuxième trame de données structurées (Ds) correspondante, chaque deuxième trame comportant un deuxième identifiant (23) de ladite trame parmi la pluralité de deuxièmes trames, le deuxième identifiant (23) étant un nombre unique pour chaque deuxième trame de données structurées (Ds).

2. Dispositif (10) selon la revendication 1, dans lequel le format de structuration (F) est défini par un descriptif (D) en forme d'un fichier au format XML ou JSON.

3. Dispositif (10) selon l'une des revendications précédentes, dans lequel les données structurées (Ds) sont constituées de caractères alphanumériques.

4. Lecteur électronique (14) comprenant un organe (19) de lecture d'un code matriciel à deux dimensions (25), le code matriciel à deux dimensions (25) étant apte à être affiché par un dispositif (10) conforme à l'une des revendications précédentes, l'organe de lecture (19) étant en outre apte à déterminer les données structurées (Ds) correspondant au code matriciel (25) lu,
**caractérisé en ce qu'**il comprend en outre un organe de décodage (20) apte à déterminer, en fonction du premier identifiant (22), les données de mesure (Dm) contenues dans les données structurées (Ds), les données de mesure (Dm) comportant des premières trames successives de données, chaque première trame de données de mesure (Dm) correspondant à une deuxième trame de données structurées (Ds), chaque deuxième trame comportant un deuxième identifiant (23) de ladite trame parmi la pluralité de deuxièmes trames, le deuxième identifiant (23) étant un nombre unique pour chaque deuxième trame de données structurées (Ds).

5. Lecteur (14) selon la revendication 4, dans lequel l'organe de décodage (20) est apte à récupérer un descriptif (D) du format de structuration (F) correspondant au premier identifiant (22) du format de structuration (F), et apte à utiliser ledit descriptif (D) pour déterminer les données de mesure (Dm) contenues dans les données structurées (Ds).

6. Lecteur (14) selon la revendication 5, dans lequel l'organe de décodage (20) est apte à récupérer le descriptif (D) du format de structuration (F) depuis un serveur informatique via le réseau Internet.

7. Lecteur (14) selon la revendication 5 ou 6, dans lequel l'organe de décodage (20) est apte à transmettre, à un appareil électronique (21) externe au lecteur (14), les données de mesure (Dm) contenues dans les données structurées (Ds) et le descriptif (D) du format (F) correspondant au premier identifiant (22).

8. Installation électronique (8) de mesure d'une grandeur (12), telle qu'une grandeur électrique ou une grandeur thermodynamique, **caractérisée en ce qu'**elle comprend un dispositif (10) conforme à l'une quelconque des revendications 1 à 3 et un lecteur (14) conforme à l'une quelconque des revendications 4 à 7.

9. Procédé de transmission de données de mesure d'une grandeur (12), telle qu'une grandeur électrique ou une grandeur thermodynamique, entre un dispositif électronique (10) de mesure de la grandeur (12) et un lecteur électronique (14),
le procédé comprenant les étapes suivantes :
- une étape (110) de codage des données de mesure (Dm), au cours de laquelle des données de mesure (Dm) sont converties, par le dispositif (10), en données structurées (Ds) selon un format de structuration (F), les données structurées (Ds) selon le format de structuration (F) comportant au moins une partie des données de mesure (Dm),
- une étape (115) de génération, par le dispositif (10), d'au moins un code matriciel à deux dimensions (25) à partir des données structurées (Ds),
- une étape (120) d'affichage, par le dispositif (10), de chaque code matriciel généré (25),
- une étape (130) de lecture, par le lecteur (14), du ou des codes matriciels affichés (25), et
- une étape (140) de détermination, par le lecteur (14), des données de mesure (Dm) contenues dans les données structurées (Ds),
**caractérisé en ce que** les données structurées (Ds) comprennent un premier identifiant (22) du format de structuration (F), le premier identifiant (22) étant apte à identifier de manière unique le format de structuration (F), et
**en ce que** ledit premier identifiant (22) est utilisé lors de l'étape de détermination (140),
les données de mesure (Dm) comportant des premières trames successives de données, l'organe de codage (16) convertissant, au cours de l'étape (110) de codage, chaque première trame de données de mesure (Dm) en une deuxième trame de données structurées (Ds) correspondante, chaque deuxième trame comportant un deuxième identifiant (23) de ladite trame parmi la pluralité de deuxièmes trames, le deuxième identifiant (23) étant un nombre unique pour chaque deuxième trame de données structurées (Ds).

10. Procédé selon la revendication 9, dans lequel, lors de l'étape de détermination (140), le lecteur (14) récupère un descriptif (D) du format de structuration (F) correspondant au premier identifiant (22), et utilise ledit descriptif (D) pour déterminer les données de mesure (Dm) contenues dans les données structurées (Ds).

## Patentansprüche

1. Elektronische Vorrichtung (10) zur Messung einer Größe (12), wie einer elektrischen Größe oder einer thermodynamischen Größe, mit:
- einem Organ (15) zur Messung der Größe (12), das in der Lage ist, Messdaten (Dm) zu liefern,
- einem Codierungsorgan (16), das in der Lage ist, Messdaten (Dm) in strukturierte Daten (Ds) nach einem Strukturierungsformat (F) zu konvertieren, wobei die nach dem Strukturierungsformat (F) strukturierten Daten (Ds) mindestens einen Teil der Messdaten (Dm) enthalten,
- einem Organ (17) zur Generierung von mindestens einem zweidimensionalen Matrix-Code (25) aus den strukturierten Daten (Ds), und
- einem Anzeigeorgan (18), das in der Lage ist, jeden generierten Matrix-Code (25) anzuzeigen,
**dadurch gekennzeichnet, dass** die strukturierten Daten (Ds) außerdem eine erste Kennung (22) des Strukturierungsformats (F) enthalten, wobei die erste Kennung (22) in der Lage ist, das Strukturierungsformat (F) eindeutig zu identifizieren,
die Messdaten (Dm) aufeinanderfolgende erste Rahmen von Daten enthalten und das Codierungsorgan (16) in der Lage ist, jeden ersten Rahmen von Messdaten (Dm) in einen korrespondierenden zweiten Rahmen von strukturierten Daten (Ds) zu konvertieren, wobei jeder zweite Rahmen eine zweite Kennung (23) des genannten Rahmens unter der Vielzahl von zweiten Rahmen enthält, und wobei die zweite Kennung (23) eine eindeutige Zahl für jeden der zweiten Rahmen von strukturierten Daten (Ds) darstellt.

2. Vorrichtung (10) nach Anspruch 1, bei der das Strukturierungsformat (F) durch einen Deskriptor (D) in Form einer Datei im XML oder JSON Format definiert ist.

3. Vorrichtung (10) nach einem der vorherigen Ansprüche, bei der die strukturierten Daten (Ds) von alphanumerischen Zeichen gebildet sind.

4. Elektronischer Leser (14) mit einem Organ (19) zum Lesen eines zweidimensionalen Matrix-Codes (25), wobei der zweidimensionale Matrix-Code (25) dazu geeignet ist, von einer Vorrichtung (10) gemäß einem der vorherigen Ansprüche angezeigt zu werden, wobei das Organ zum Lesen (19) außerdem in der Lage ist, die strukturierten Daten (Ds) korrespondierend zu dem gelesenen Matrix-Code (25) zu ermitteln,
**dadurch gekennzeichnet, dass** er ferner ein Dekodierungsorgan (20) aufweist, das in der Lage ist, in Abhängigkeit von der ersten Kennung (22), die Messdaten (Dm), die in den strukturierten Daten (Ds) enthalten sind, zu ermitteln, wobei die Messdaten (Dm) aufeinanderfolgende erste Rahmen von Daten enthalten, wobei jeder erste Rahmen aus Messdaten (Dm) zu einem zweiten Rahmen aus strukturierten Daten (Ds) korrespondiert, wobei jeder zweite Rahmen eine zweite Kennung (23) des genannten Rahmens unter der Vielzahl der zweiten Rahmen enthält, und wobei die zweite Kennung (23) eine eindeutige Zahl für jeden der zweiten Rahmen aus strukturierten Daten (Ds) ist.

5. Leser (14) nach Anspruch 4, bei dem das Dekodierungsorgan (20) in der Lage ist, einen Deskriptor (D) des Strukturierungsformats (F) korrespondierend zu der ersten Kennung (22) des Strukturierungsformats (F) zu erlangen, und in der Lage ist, diesen Deskriptor (D) zu benutzen, um die Messdaten (Dm), die in den strukturierten Daten (Ds) enthalten sind, zu ermitteln.

6. Leser (14) nach Anspruch 5, bei dem das Dekodierungsorgan (20) in der Lage ist den Deskriptor (D) des Strukturierungsformats (F) von einem Computer-Server über das Internet-Netzwerk zu erlangen.

7. Leser (14) nach Anspruch 5 oder 6, bei dem das Dekodierungsorgan (20) in der Lage ist, die in den strukturierten Daten (Ds) enthaltenen Messdaten (Dm) und den Deskriptor (D) des Formats (F), korrespondierend zu der ersten Kennung (22), an ein sich außerhalb des Lesers (14) befindliches elektronisches Gerät (21) zu übermitteln.

8. Elektronische Anlage (8) zur Messung einer Größe (12), wie einer elektrischen Größe oder einer thermodynamischen Größe, **dadurch gekennzeichnet, dass** sie eine elektronische Vorrichtung (10) gemäß einem der Ansprüche 1 bis 3 und einen Leser (14) gemäß einem der Ansprüche 4 bis 7 umfasst.

9. Verfahren zum Übertragen von Messdaten einer Größe (12), wie einer elektrischen Größe oder einer thermodynamischen Größe, zwischen einer elektronischen Vorrichtung (10) zur Messung der Größe (12) und einem elektronischen Leser (14),
wobei das Verfahren folgende Schritte umfasst:
- einen Schritt (110) der Codierung von Messdaten (Dm), während dessen Messdaten (Dm) durch die Vorrichtung (10) in strukturierte Daten (Ds) gemäß einem Strukturierungsformat (F), wobei die nach dem Strukturierungsformat (F) strukturierten Daten (Ds) mindestens einen Teil der Messdaten (Dm) enthalten, konvertiert werden,
- einen Schritt (115) der Erzeugung, durch die Vorrichtung (10), von mindestens einem zweidimensionalen Matrix-Code (25) anhand der strukturierten Daten (Ds),
- einen Schritt (120) der Anzeige, durch die Vorrichtung (10), von jedem erzeugten Matrix-Code (25),
- einen Schritt (130) des Lesens, durch den Leser (14), des oder der angezeigten Matrix-Codes (25), und
- einen Schritt (140) der Ermittlung, durch den Leser (14), der in den strukturierten Daten (Ds) enthaltenen Messdaten (Dm),
**dadurch gekennzeichnet, dass** die strukturierten Daten (Ds) eine erste Kennung (22) des Strukturierungsformats (F) enthalten, wobei die erste Kennung (22) in der Lage ist, das Strukturierungsformat (F) eindeutig zu identifizieren, und
dass die genannte erste Kennung (22) während des Ermittlungsschrittes (140) verwendet wird,
wobei die Messdaten (Dm) aufeinanderfolgende erste Rahmen von Daten enthalten, das Codierungsorgan (16) während des Codierungsschrittes (110) jeden ersten Rahmen von Messdaten (Dm) in einen korrespondierenden zweiten Rahmen von strukturierten Daten (Ds) konvertiert, wobei jeder zweite Rahmen eine zweite Kennung (23) des genannten Rahmens unter der Vielzahl der zweiten Rahmen enthält, und wobei die zweite Kennung (23) eine eindeutige Zahl für jeden der zweiten Rahmen von strukturierten Daten (Ds) ist.

10. Verfahren nach Anspruch 9, bei dem während des Ermittlungsschrittes (140) der Leser (14) einen Deskriptor (D) des Strukturierungsformats (F) korrespondierend zu der ersten Kennung (22) erlangt und den genannten Deskriptor (D) verwendet, um die Messdaten (Dm), die in den strukturierten Daten (Ds) enthalten sind, zu ermitteln.

## Claims

1. An electronic device (10) for measuring a quantity (12), such as an electric quantity or a thermodynamic quantity, comprising:
- a unit (15) for measuring the quantity (12), able to deliver measurement data (Dm),
- an encoding unit (16), able to convert measurement data (Dm) into structured data (Ds) according to a structuration format (F), the data (Ds) structured according to the structuration format (F) including at least one portion of the measurement data (Dm),
- a unit (17) for generating at least one two-dimensional matrix code (25) from the structured data (Ds), and
- a display unit (18), able to display each generated matrix code (25),
**characterized in that** the structured data (Ds) further comprise a first identifier (22) of the structuration format (F), said first identifier (22) being able to exclusively identify the structuration format (F),
the measurement data (Dm) including successive first frames of data, and the encoding unit (16) being able to convert each first frame of measurement data (Dm) into a corresponding second frame of structured data (Ds), each second frame including a second identifier (23) of said frame from among the plurality of second frames, the second identifier (23) being a number unique for each second frame of structured data (Ds).

2. The device (10) according to claim 1, wherein the structuration format (F) is defined by a descriptor (D) in the form of a file with an XML or JSON format.

3. The device (10) according to one of the previous claims, wherein the structured data (Ds) consist of alphanumerical characters.

4. An electronic reader (14) comprising a unit (19) for reading a two-dimensional matrix code (25), the two-dimensional matrix code (25) being able to be displayed by a device (10) according to one of the previous claims, the reading unit (19) further being able to determine the structured data (Ds) corresponding to the matrix code (25) read,
wherein the reader (14) further comprises a decoding unit (20) able to determine, depending on the first identifier (22), the measurement data (Dm) contained in the structured data (Ds), the measurement data (Dm) including successive first frames of data, each first frame of measurement data (Dm) corresponding to a second frame of structured data (Ds), each second frame including a second identifier (23) of said frame from among the plurality of second frames, the second identifier (23) being a number unique for each second frame of structured data (Ds).

5. The reader (14) according to claim 4, wherein the decoding unit (20) is able to retrieve a descriptor (D) of the structuration format (F) corresponding to the first identifier (22) of the structuration format (F), and able to use said descriptor (D) for determining the measurement data (Dm) contained in the structured data (Ds).

6. The reader (14) according to claim 5, wherein the decoding unit (20) is able to retrieve the descriptor (D) of the structuration format (F) from a computer server via the Internet network.

7. The reader (14) according to claim 5 or 6, wherein the decoding unit (20) is able to transmit, to an electronic apparatus (21) external to the reader (14), the measurement data (Dm) contained in the structured data (Ds) and the descriptor (D) of the format (F) corresponding to the first identifier (22).

8. An electronic installation (8) for measuring a quantity (12), such as an electric quantity or a thermodynamic quantity, wherein the installation (8) comprises a device (10) according to any one of claims 1 to 3 and a reader (14) according to any one of claims 4 to 7.

9. A method for transmitting measurement data (Dm) of a quantity (12), such as an electric quantity or a thermodynamic quantity, between an electronic device (10) for measuring the quantity (12) and an electronic reader (14),
the method comprising the following steps:
- a step (110) for encoding measurement data (Dm), during which measurement data (Dm) are converted, by the device (10), into data (Ds) structured according to a structuration format (F), the data (Ds) structured according to the structuration format (F) including at least one portion of the measurement data (Dm),
- a step (115) for generating, by the device (10), at least one two-dimensional matrix code (25) from the structured data (Ds),
- a step (120) for displaying, by the device (10), each generated matrix code (25),
- a step (130) for reading, by the reader (14), displayed matrix code(s) (25), and
- a step (140) for determining, by the reader (14), measurement data (Dm) contained in the structured data (Ds),
**characterized in that** the structured data (Ds) comprise a first identifier (22) of the structuration format (F), the first identifier (22) being able to exclusively identify the structuration format (F), and
**in that** said first identifier is used in the determination step, the measurement data (Dm) including successive first frames of data, and the encoding unit (16) converting, during the step (110) for encoding, each first frame of measurement data (Dm) into a corresponding second frame of structured data (Ds), each second frame including a second identifier (23) of said frame from among the plurality of second frames, the second identifier (23) being a number unique for each second frame of structured data (Ds).

10. The method according to claim 9, wherein, during the determination step (140), the reader (14) retrieves a descriptor (D) of the structuration format (F) corresponding to the first identifier (22), and uses said descriptor (D) for determining the measurement data (Dm) contained in the structured data (Ds).
